# EUROPEAN PATENT APPLICATION

(11) **EP 4 773 762 A1**
(43) Date of publication of application: **08.07.2026**
(21) Application number: 23956873.6
(22) Date of filing: 24.10.2023
(51) Int. Cl.: H10H 20/831, H10H 20/813, H10H 20/857, H10H 20/855, H10H 20/00

(54) **LIGHT-EMITTING ELEMENT PACKAGE AND DISPLAY DEVICE USING SAME**

(71) Applicant: LG Electronics Inc., Yeongdeungpo-gu Seoul 07336 (KR)
(72) Inventor: CHOI, Hwanjoon, Seoul 06772 (KR)
(74) Representative: Schott, Jakob Valentin
(86) International application number: PCT/KR2023/016528
(87) International publication number: WO 2025/089437

(57) **Abstract**

The present invention is applicable to the technical field related to display devices, and for example, relates to a light-emitting element package and a display device using a light-emitting diode (LED). The present invention comprises: a first layer having a light-emitting portion including light-emitting elements forming unit subpixels; a second layer positioned on a first surface of the first layer and including a terminal portion and a plurality of connection electrodes connecting a gap between the terminal portion and the light-emitting elements; a third layer positioned on the second surface of the first layer and through which light emitted from the light-emitting portion passes, wherein the connection electrodes may have a pillar structure having a height corresponding to the gap and an inclination angle with respect to the first surface.

## Description

### [Technical Field]

The present disclosure may be applied to the technical field related to a display device, and relates to, for example, a light-emitting element package using a light-emitting diode (LED) and a display device using the same.

### [Background]

In a field of a display technology, display devices having excellent characteristics such as thinness, flexibility, and the like have been developed. On the other hand, currently commercialized major displays are represented by a LCD (liquid crystal display) and an OLED (organic light-emitting diode).

On the other hand, LED (light-emitting diode), which is a well-known semiconductor light-emitting element that converts electric current into light, has been used as a light source for a display image of an electronic device including an information and communication device along with a GaP:N-based green LED, starting with commercialization of a red LED using a GaAsP compound semiconductor in 1962.

Recently, the light-emitting diode (LED) has been gradually miniaturized to be manufactured into a micrometer-sized LED which is used as a pixel of the display device.

The LED exhibits characteristics of low power, high luminance, and high reliability compared to other types of display elements/panels, and may be applied to a flexible element. Therefore, research thereon has been actively conducted in research institutes and companies in recent years.

Various markets of the LED display are expanding into applications that utilize the characteristics of the high luminance and high reliability of the LED. The field that is leading the market due to these characteristics is a signage display.

In such a display, the LED may be manufactured in the form of a package that may be used as a unit pixel. When a mini LED having a size of a millimeter scale is used, such a LED package may include a support layer generally including a sapphire substrate. In general, the support layer may be relatively much thicker than the light-emitting layer included in the LED. When the support layer is thick, an amount of light emitted from the LED package and then travelling laterally may increase. The light travelling laterally may be considered a loss from the viewpoint of the display device.

In a display such as a passive matrix (PM) type signage, a mini LED capable of high luminance according to a driving scheme such as pulse width modulation (PWM) is mounted and applied. Recently, with the aim of increasing efficiency and reducing the cost, a light-emitting element package (RGB package chip) to which a micro LED is applied and which may be used as an individual pixel has been developed.

Using such a light-emitting element package, the cost of a chip-on-wafer in which a chip is provided in a state of being formed on a wafer, the cost of mounting a wiring substrate, and the cost of simplifying a panel process after mounting the LED may be reduced.

However, when the micro LED in place of the mini LED is applied to the light-emitting unit, it may be difficult to apply the micro LED having a size smaller than a predetermined size due to a phenomenon (droop) in which efficiency is lowered according to a current density of the current injected into the LED.

Moreover, in the process in which the size of the micro LED is deceased, it may be difficult to pre-test the chip, and it may be difficult to apply a pick-up & place process of mounting an individual chip on a substrate as currently applied to mass production technology.

In addition, there is a need for an approach for solving problems that may occur as the size of the chip decreases.

### [Summary]

### [Technical Purpose]

A technical purpose of the present disclosure is to provide a light-emitting element package capable of stably connecting components of layers constituting the light-emitting element package to each other, and a display device using the same.

In addition, a technical purpose of the present disclosure is to provide a light-emitting element package which may increase a contact area using a structure of a connection electrode and thus secure a stable electrical connection, and a display device using the same.

A technical purpose of the present disclosure is to provide a light-emitting element package which may improve the thickness of the light-emitting element package having excellent characteristics using the structure of the connection electrode, thereby improving durability thereof, and a display device using the same.

Accordingly, a technical purpose of the present disclosure is to provide a light-emitting element package capable of improving the reliability of the light-emitting element package against an external environment, and a display device using the same.

Furthermore, it will be understood by those skilled in the art through purposes of the specification and drawings that there may be additional technical purpose as not mentioned herein according to another embodiment of the present disclosure.

### [Technical Solution]

According to a first aspect of the present disclosure to achieve the above purpose, there is provided a light-emitting element package comprising: a first layer including a light-emitting unit including light-emitting elements, each light-emitting element constituting a unit sub-pixel; a second layer disposed on a first surface of the first layer, wherein the second layer may include a terminal and a plurality of connection electrodes connecting the terminal to the light-emitting elements; and a third layer disposed on a second surface of the first layer, wherein light emitted from the light-emitting unit passes through the third layer, wherein the connection electrode may have a pillar structure having a vertical length corresponding to a vertical spacing between the terminal and the light-emitting elements, wherein the pillar structure may have an inclination angle with respect to the first surface.

In an embodiment, the connection electrode may be positioned on an outer surface of a pillar-shape provided in the second layer.

In an embodiment, the connection electrode may have an inclination angle with respect to the pillar-shape.

In an embodiment, an inclined portion having an inclination angle may be positioned on an outer surface of the pillar-shape.

In an embodiment, the connection electrode may include: a first contact and connection portion contacting and connected to the terminal; and a second contact and connection portion contacting and connected to the light-emitting element.

In an embodiment, the connection electrode may further include a third contact and connection portion connected to and disposed between the first contact and connection portion and the second contact and connection portion.

In an embodiment, the third contact and connection portion may have the inclination angle.

In an embodiment, the terminal may have a pillar structure corresponding to the connection electrode.

In an embodiment, the light-emitting element package may further comprise a driving element disposed on one side of the light-emitting element.

In an embodiment, the light-emitting element package may further comprise a fourth layer disposed between the third layer and the first layer and containing scattering particles therein.

In an embodiment, the second layer may function as a reflective layer.

According to a second aspect of the present disclosure to achieve the above purpose, there is provided a light-emitting element package comprising: a light-emitting layer including a light-emitting unit including light-emitting elements, each light-emitting element constituting a unit sub-pixel; a connection layer disposed on a first surface of the light-emitting layer, wherein the connection layer may include a terminal and a plurality of connection electrodes connected to and disposed between the terminal and the light-emitting elements; and a support layer disposed on a second surface of the light-emitting layer, wherein light emitted from the light-emitting unit passes through the support layer, wherein the connection electrode may have a metal pattern shape positioned on a pillar-shape including an inclined portion provided in the connection layer.

In an embodiment, the metal pattern may be positioned on an outer surface of the pillar-shaped structure provided in the connection layer.

In an embodiment, the light-emitting element package may further comprise a scattering layer disposed between the light-emitting layer and the support layer and containing scattering particles therein.

According to a third aspect of the present disclosure to achieve the above purpose, there is provided a display device including a light-emitting element package defining an individual pixel, wherein the light-emitting element package may comprise: a light-emitting layer including a light-emitting unit including light-emitting elements, each light-emitting element constituting a unit sub-pixel; a connection layer disposed on a first surface of the light-emitting layer, wherein the connection layer may include a terminal and a plurality of connection electrodes connected to and disposed between the terminal and the light-emitting elements; and a support layer disposed on a second surface of the light-emitting layer, wherein light emitted from the light-emitting unit passes through the support layer, wherein the connection electrode may have a metal pattern shape positioned on a pillar-shape including an inclined portion provided in the connection layer.

### [Advantageous Effects]

According to an embodiment of the present disclosure, there are the following effects.

First, according to an embodiment of the present disclosure, the components of the layers constituting the light-emitting element package may be stably connected to each other using the connection electrode having a structure having a smaller inclination than that of the through hole structure (via hole structure).

In addition, the contact area may be expanded using the structure of the connection electrode, and accordingly, stable electrical connection may be secured.

Using the structure of the connection electrode, the thickness of the light-emitting element package having excellent characteristics may be improved, and accordingly, durability thereof may be improved.

Accordingly, the reliability of the light-emitting element package against the external environment may be improved.

Furthermore, according to another embodiment of the present disclosure, there are additional technical effects not mentioned herein. Those skilled in the art may understand this based on all of the purposes of the specification and drawings.

### [Brief Description of Drawings]

FIG. 1 is a cross-sectional view illustrating a light-emitting element package according to a first embodiment of the present disclosure.
FIG. 2 is a plan view illustrating a light-emitting element package according to a first embodiment of the present disclosure.
FIG. 3 is an enlarged view showing a pillar-shaped structure and an inclined portion of the light-emitting element package according to the first embodiment of the present disclosure.
FIG. 4 is a cross-sectional schematic view illustrating an example of a connection electrode according to an up-hill structure shape of a light-emitting element package according to a first embodiment of the present disclosure.
FIG. 5 is a cross-sectional view illustrating a light-emitting element package according to a second embodiment of the present disclosure.
FIG. 6 is a cross-sectional view illustrating a light-emitting element package according to a third embodiment of the present disclosure.
FIG. 7 is a cross-sectional view illustrating a light-emitting element package according to a fourth embodiment of the present disclosure.
FIG. 8 is a cross-sectional view illustrating a light-emitting element package according to a fifth embodiment of the present disclosure.
FIGS. 9 to 11 are cross-sectional views illustrating a light-emitting element package according to a sixth embodiment of the present disclosure and a modified example thereof.
FIG. 12 is a schematic diagram illustrating an example in which a connection electrode is used as an alignment key according to embodiments of the present disclosure.
FIG. 13 is a schematic diagram illustrating an example in which a terminal is used as an alignment key according to embodiments of the present disclosure.
FIG. 14 is a schematic cross-sectional view illustrating a display device using the light-emitting element package according to the first embodiment of the present disclosure.
FIGS. 15 to 24 are cross-sectional views illustrating a process of manufacturing the light-emitting element package according to the first embodiment.

### [Best Mode]

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, area or module is described as being "on" another element, it is to be understood that the element may be directly on the other element or there may be an intermediate element between them.

A semiconductor light-emitting element mentioned herein is a concept including a LED, a micro LED, and the like, and the semiconductor light-emitting element, the LED, the micro LED may be used interchangeably with each other.

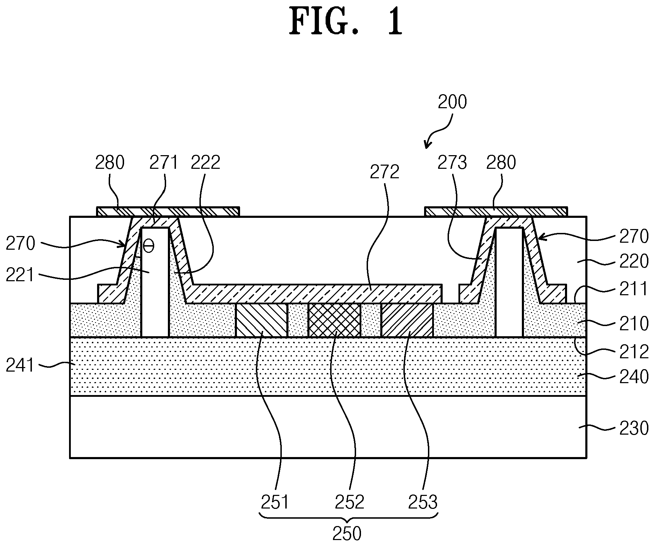

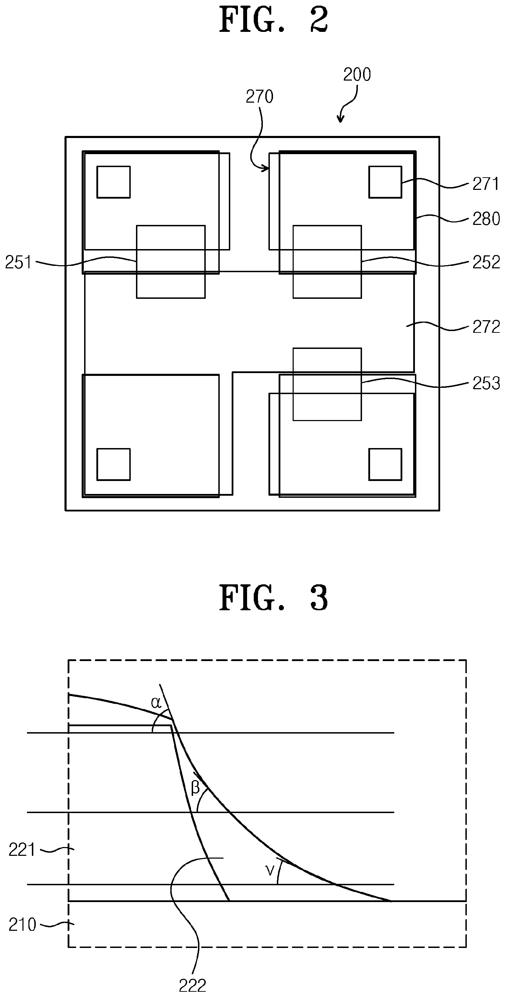

FIG. 1 is a cross-sectional view illustrating a light-emitting element package according to a first embodiment of the present disclosure. FIG. 2 is a plan view illustrating a light-emitting element package according to a first embodiment of the present disclosure.

FIG. 1 schematically illustrates a light-emitting element package according to a first embodiment. Accordingly, the structures of FIGS. 1 and 2 may not be exactly identical with each other. In one example, a configuration of a light-emitting unit 250 in FIG. 1 may be schematically illustrated for convenience of illustration.

Referring to FIGS. 1 and 2, a light-emitting element package 200 according to the first embodiment of the present disclosure may include a light-emitting layer 210 (or a first layer) in which a light-emitting unit 250 including light-emitting elements 251, 252, and 253 is located.

The light-emitting unit 250 may include a first light-emitting element 251, a second light-emitting element 252, and a third light-emitting element 253. In one example, the first light-emitting element may be a red light-emitting element (R), the second light-emitting element may be a green light-emitting element (G), and the third light-emitting element may be a blue light-emitting element (B). In some cases, at least one of the first light-emitting element (R), the second light-emitting element (G), and the third light-emitting element (B) may include two or more light-emitting elements.

When the light-emitting element package 200 is used in a display device, each of the first light-emitting element 251, the second light-emitting element 252, and the third light-emitting element 253 may correspond to an individual sub-pixel. The first light-emitting element 251, the second light-emitting element 252, and the third light-emitting element 253 may constitute a unit pixel in the display device.

Each of the light-emitting elements 251, 252, and 253 constituting the light-emitting unit 250 may be a mini LED having a size of a millimeter scale or a micro LED having a size of a micrometer scale.

A connection layer 220 (or a second layer) including a terminal 280 and a plurality of connection electrodes 270 connected to and disposed between the terminal 280 and the light-emitting elements 251, 252, and 253 may be positioned on a first surface 211 of the light-emitting layer 210.

A support layer 230 (or a third layer) through which light emitted from the light-emitting unit 250 passes may be positioned on a second surface 212 of the light-emitting layer 210. That is, light generated from the light-emitting unit 250 may be emitted through the support layer 230. As described above, the light-emitting element package as shown in FIG. 1 may be a bottom emission type light-emitting element package in which light is emitted downwardly of the structure shown in FIG. 1.

In this regard, the connection electrode 270 may have a metal pattern shape 271, 272, and 273 positioned on an inclined portion 222 surrounding an insulating pillar-shape 221 provided in the connection layer 220.

In one example, the inclined portion 222 may have an inclination angle with respect to a main plane of the connection layer 220. FIG. 1 illustrates an example in which the inclined portion 222 has an inclination angle θ with respect to an imaginary line perpendicular to the main plane of the connection layer 220.

In this way, in an embodiment, the connection electrode 270 may be positioned on an outer surface of the pillar-shape 221 provided in the connection layer (or the second layer) 220. Accordingly, the connection electrode 270 may have an inclination angle with respect to the pillar-shape 221.

Referring to FIG. 1, in an embodiment, the inclined portion 222 having an inclination angle θ may be located so as to surround the pillar-shape 221.

In one example, an insulating support shape having an inclination may be composed of the pillar-shape 221 and the inclined portion 222, and the connection electrode 270 having the metal pattern shape 271, 272, and 273 may be disposed along the outer surface of the support shape.

The connection electrode 270 having the metal pattern shape 271, 272, and 273 may have a structure in which a via electrode shape formed along a via hole is modified. Hereinafter, for convenience of illustration, the shape corresponding to the via hole may be referred to as an up-hill structure. In addition, a structure of the connection electrode 270 formed on the up-hill structure may be referred to as an up-hill electrode.

In an embodiment, the connection electrode 270 may include a first contact and connection portion 271 contacting and connected to the terminal 280 and a second contact and connection portion 272 contacting and connected to the light-emitting elements 251, 252, and 253.

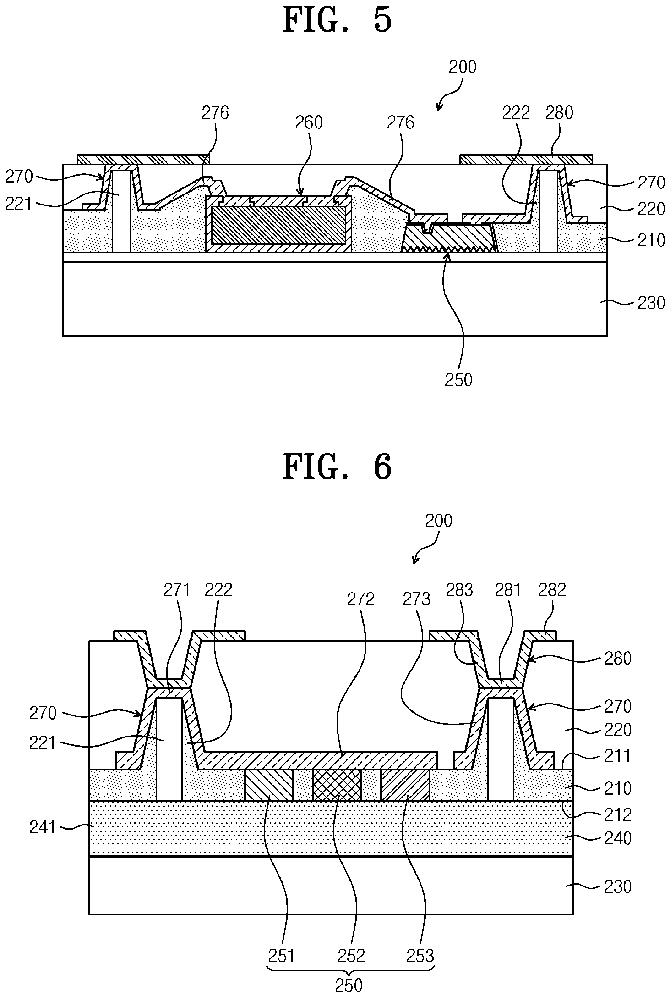

Referring to FIGS. 1 and 2, the first contact and connection portion 271 of the connection electrode 270 may be electrically connected to the terminal 280. In FIG. 2, the second contact and connection portion 272 is schematically illustrated. In one example, the second contact and connection portion 272 may be a common electrode commonly connected to the first light-emitting element 251, the second light-emitting element 252, and the third light-emitting element 253. The second contact and connection portion 272 may be connected to any one of the four terminals 280. In an example, a turn-on signal may be transmitted to each of the first light-emitting element 251, the second light-emitting element 252, and the third light-emitting element 253 through the first contact and connection portion 271 connected to each of the remaining three of the four terminals 280. In another example, the light-emitting element package 200 may be separately provided with a driving element 260 (see FIG. 5) for driving the light-emitting unit 250. Accordingly, the first light-emitting element 251, the second light-emitting element 252, and the third light-emitting element 253 may be individually driven through the driving element 260.

In one example, a third contact and connection portion 273 connected to and disposed between the first contact and connection portion 271 and the second contact and connection portion 272 may be provided. In this regard, the third contact and connection portion 273 may have an inclination angle corresponding to an inclination angle of the inclined portion 222. The third contact and connection portion 273 may substantially define a height of the connection electrode 270. In one example, the third contact and connection portion 273 may have a height corresponding to a vertical spacing between the terminal 280 and the light-emitting unit 250. Such a height may correspond to the height of the pillar-shape 221.

The connection electrode 270 having such an up-hill structure may have an increased effective area compared to a through electrode or a pillar-shaped electrode formed in the same area. The effect of the structure of the connection electrode 270 will be described in detail later.

In an embodiment, a fourth layer 240 (or a scattering layer) including fine particles 241 may be located between the support layer (or the third layer) 230 and the light-emitting layer (or the first layer) 210.

The fine particles 241 may have a size of micrometers or nanometers. These fine particles may be light scattering particles. The fine particles may have a refractive index of 1.3 or greater.

The fine particles may include at least one of a metal oxide, a resin particle, and an inorganic oxide. In one example, the fine particles may include at least one of TiO₂, ZnO₂, ZrO₂, MgF₂, SnO₂, ITO, SiNₓ, Silica, and PMMA.

In one example, the fine particles may be used for the purpose of improving the viewing angle for preventing color temperature deviation according to the light emission angle of the light emitted from the light-emitting unit 250 from the third layer 230.

In an embodiment, the light-emitting layer 210 may function as a reflective layer. In one example, the light-emitting layer 210 may also include fine particles to act as a reflective layer. In this regard, a content of the fine particles included in the light-emitting layer 210 may be greater than a content of the fine particles included in the fourth layer 240 (or the scattering layer).

In one example, the inclined portion 222 constituting the up-hill structure may have the same physical properties as those of the light-emitting layer 210. That is, as the light-emitting layer 210 acts as the reflective layer, the inclined portion 222 may function as a reflective layer.

In a display such as a passive matrix (PM) type signage, a mini LED capable of high luminance according to a driving scheme such as pulse width modulation (PWM) is mounted and applied. Recently, with the aim of increasing efficiency and reducing the cost, a light-emitting element package (RGB package chip) to which a micro LED is applied and which may be used as an individual pixel has been developed.

Using such a light-emitting element package, the cost of a chip-on-wafer in which a chip is provided in a state of being formed on a wafer, the cost of mounting a wiring substrate, and the cost of simplifying a panel process after mounting the LED may be reduced.

However, when the micro LED in place of the mini LED is applied to the light-emitting unit, it may be difficult to apply the micro LED having a size smaller than a predetermined size due to a phenomenon (droop) in which efficiency is lowered according to a current density of the current injected into the LED.

Moreover, in the process in which the size of the micro LED is deceased, it may be difficult to pre-test the chip, and it may be difficult to apply a pick-up & place process of mounting an individual chip on a substrate as currently applied to mass production technology.

Accordingly, as in an embodiment of the present disclosure, the micro LED mag be transferred on a process substrate such as a temporary substrate or a support substrate and then an additional wiring process may be performed thereon such that a package structure that can be inspected may be manufactured, and be applied.

When the area of the light-emitting element package is sufficiently large, the package may have a structure in which the micro LED and the terminal pillar structure non-overlap each other. Accordingly, it may be necessary to reduce the size of the light-emitting element package in order to apply as many light-emitting element packages as possible to the process substrate. In addition, it is necessary to secure a size according to the electrode spacing of a wiring substrate in the reduced sized light-emitting element package.

In an operation of the signage of the AM (active matrix) type or the AM/PM combined type using the micro IC as the driving element, time division turn-on is not required. Thus, the size thereof may be smaller than that of the PM driving micro LED.

However, it is necessary to secure a space into which the micro IC is transferred. As the circuit complexity increases due to the connection between the micro LED and the driving element, the size of the light-emitting element package may increase in order to secure the pillar structure connected to the terminal.

When the micro IC is used, it may be required to reduce the package size in order to reduce the process cost and increase productivity.

In the light-emitting element package having a size of 200 *µ*m or smaller, an area in which the terminal and the micro LED, and in some cases, the driving element overlap each other, and an area which the connection layer including the metal pattern connected to the micro LED faces may occur.

As the side inclination θ of the connection electrode 270 becomes gentle, reliability against external environments such as solder heat treatment/heat shock/high temperature and high humidity may be increased in the process of mounting the light-emitting element package on the wiring substrate. In one example, when the terminal is manufactured using a thin film deposition process through a sputtering method or the like rather than a plating process, the above effect may be increased.

To this end, according to an embodiment of the present disclosure, as shown in FIGS. 1 and 2, the up-hill structure may be applied to the connection layer 220 connecting the terminal 280 and the light-emitting unit 250 to each other.

As described above, the connection electrode 270 having a structure having an inclination smaller than that of the through hole structure (via hole structure) may be used to stably connect the components of the layers constituting the light-emitting element package 200 to each other.

In addition, a contact area may be increased using the structure of the connection electrode 270, and accordingly, stable electrical connection may be secured.

Using the structure of the connection electrode 270, the thickness of the light-emitting element package 200 having excellent characteristics may be improved, and accordingly, durability thereof may be improved.

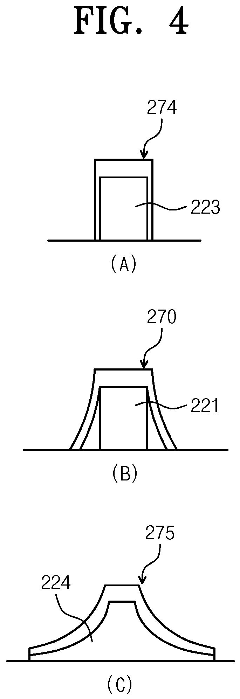

FIG. 3 is an enlarged view showing a pillar-shaped structure and an inclined portion of the light-emitting element package according to the first embodiment of the present disclosure. FIG. 4 is a cross-sectional schematic view illustrating an example of a connection electrode according to an up-hill structure shape of a light-emitting element package according to the first embodiment of the present disclosure.

As described above, for electrical connection between the terminal 280 and the light-emitting unit 250 or between the terminal 280 and the third contact and connection portion 273 connected to the light-emitting unit 250, the connection electrode 270 having a so-called up-hill structure having the metal pattern shape 271, 272, and 273 disposed on the pillar-shaped structure and the inclined portion may be used.

Referring to FIG. 3, the insulating pillar structure having the pillar-shape 221 and the inclined portion 222 may be positioned on the light-emitting layer 210.

In an embodiment, the protruding pillar-shape 221 may be formed on the light-emitting layer 210, and then, the inclined portion 222 may be formed outside the pillar-shape 221 using a liquid coating. In this regard, the side surface shape of the inclined portion 222 may be controlled by controlling a viscosity of the coating solution, solvent volatilization, gravity, surface tension, and the like, such that the inclined portion 222 has a gentle inclination.

In one example, the pillar-shape 221 may be made of a photoresist (PR) material such as a photosensitive compound resin. In this regard, the pillar-shape 221 may not be perpendicular to the light-emitting layer 210 but may have an inclination with respect thereto. This inclination may be realized according to a scheme of forming the pillar-shape 221.

Thereafter, when the inclined portion 222 is formed, the patterning may be performed on the pillar-shape 221 and then, a reflow property of the liquid coating may be utilized depending on the material. Accordingly, the inclined portion 222 having various angles α, β, and γ may be formed.

As shown in FIG. 4, the inclination angle of the connection electrode 270, 274, and 275 formed on the formed inclined structure 221, 223, and 224 may be adjusted according to the shape of the formed inclined structure 221, 223, and 224.

As described above, the thickness of the connection electrodes 270, 274, and 275 may vary according to the plane and the side angle, and may have various characteristics in connection stability at the inflection point.

In one example, as shown in (A) in FIG. 4, when the pillar-shape 221 does not have an inclination, the connection electrode 274 in the form of the through electrode may be formed along the outer surface of the pillar-shape 221 having such a perpendicular cross-section.

Referring to (B) in FIG. 4, as in the embodiment of the present disclosure, when the inclined portion 222 is formed outside the pillar-shape 221, the connection electrode 270 having the side inclination may be formed outside the pillar-shape 221 and the inclined portion 222.

In an embodiment, referring to (C) in FIG. 4, the inclined portion 224 may be formed to have a smaller inclination compared to the case illustrated in (B) in FIG. 4. In an example, the pillar-shape 221 and the inclined portion 222 may be integrally formed with each other. In addition, the connection electrode 275 having a smaller inclination may be formed on the integrally formed inclined portion 224.

FIG. 5 is a cross-sectional view illustrating a light-emitting element package according to a second embodiment of the present disclosure.

Referring to FIG. 5, the light-emitting element package 200 according to the second embodiment of the present disclosure may include the light-emitting layer 210 (or a first layer) in which the light-emitting unit 250 including the light-emitting elements 251, 252, and 253 is located. In this regard, the driving element 260 may be positioned on one side of the light-emitting unit 250 and in the light-emitting layer 210.

The driving element (driver chip) 260 may be implemented in the form of an integrated circuit (IC). The driving element 260 may drive the light-emitting unit 250. The driving element 260 may be connected to the light-emitting unit 250 to control the light-emitting color/light intensity of the light-emitting element package 200. In addition, when the light-emitting element package 200 acts as the pixel of the display device, the driving element 260 may implement active matrix (AM) driving.

When the driving element 260 as described above is provided, the connection electrode 270 may further include a fourth contact and connection portion 276 connected to the driving element 260. One side of the fourth contact and connection portion 276 may be connected to the connection electrode 270, and the other side of the fourth contact and connection portion 276 may be connected to the light-emitting unit 250.

As described above, the connection layer 220 (or the second layer) including the terminal 280 and a plurality of connection electrodes 270 connected to and disposed between the terminal 280 and the light-emitting elements 251, 252, and 253 may be positioned on the light-emitting layer 210 in which the light-emitting unit 250 is positioned.

In addition, the support layer 230 (or a third layer) through which light emitted from the light-emitting unit 250 passes may be positioned on the lower surface of the light-emitting layer 210. That is, light generated from the light-emitting unit 250 may be emitted through the support layer 230. As described above, the light-emitting element package shown in FIG. 5 may be a bottom emission type light-emitting element package in which light is emitted downwardly of the structure shown in FIG. 5.

The description of other parts not described herein may be the same as the description as set forth above with respect to the first embodiment. Therefore, a redundant description thereof will be omitted.

FIG. 6 is a cross-sectional view illustrating a light-emitting element package according to a third embodiment of the present disclosure.

Referring to FIG. 6, the light-emitting element package 200 according to the third embodiment of the present disclosure may include the light-emitting layer 210 (or a first layer) in which the light-emitting unit 250 including the light-emitting elements 251, 252, and 253 is located.

The connection layer 220 (or a second layer) including the terminal 280 and the plurality of connection electrodes 270 connected to and disposed between the terminal 280 and the light-emitting elements 251, 252, and 253 may be positioned on the light-emitting layer 210 in which the light-emitting unit 250 is located.

In addition, the support layer 230 (or a third layer) through which light emitted from the light-emitting unit 250 passes may be positioned on the lower surface of the light-emitting layer 210. That is, light generated from the light-emitting unit 250 may be emitted through the support layer 230. As described above, the light-emitting element package shown in FIG. 6 may be a bottom emission type light-emitting element package in which light is emitted downwardly of the structure shown in FIG. 6.

The connection electrode 270 may have the metal pattern shape 271, 272, and 273 positioned on the insulating pillar-shape 221 including the inclined portion 222 provided in the connection layer 220.

The connection electrode 270 having the metal pattern shape 271, 272, and 273 may have a structure (the up-hill structure) in which the through electrode (via electrode) formed along the through hole is modified.

In an embodiment, the connection electrode 270 may include the first contact and connection portion 271 contacting and connected to the terminal 280 and the second contact and connection portion 272 contacting and connected to the light-emitting elements 251, 252, and 253.

The third contact and connection portion 273 connected to and disposed between the first contact and connection portion 271 and the second contact and connection portion 272 may be included in the connection electrode 270. In this regard, the third contact and connection portion 273 may have an inclination angle corresponding to that of the inclined portion 222. The third contact and connection portion 273 may substantially define the height of the connection electrode 270. In one example, the third contact and connection portion 273 may have a height corresponding to a vertical spacing between the terminal 280 and the light-emitting unit 250. Such a height may correspond to the height of the pillar-shape 221.

The connection electrode 270 having the up-hill structure may have an increased effective area compared to the through electrode or the pillar-shaped electrode formed in the same area.

In an embodiment, the terminal 280 may have the pillar structure corresponding to the connection electrode 270. In one example, the terminal 280 may include the fifth contact and connection portion 281 connected to the first contact and connection portion 271 of the connection electrode 270, a terminal layer 282 serving as a terminal connected to the external electrode pad, and a sixth contact and connection portion 283 connecting the fifth contact and connection portion 281 and the terminal layer 282 to each other.

Like the third contact and connection portion 273 of the connection electrode 270, the sixth contact and connection portion 283 of the terminal 280 may have an inclination angle rather than a right angle with respect to the terminal layer 282. The third contact and connection portion 273 may substantially define the height of the terminal 280.

The description of other parts not described herein may be the same as the description as set forth above with respect to the first embodiment. Therefore, a redundant description thereof will be omitted.

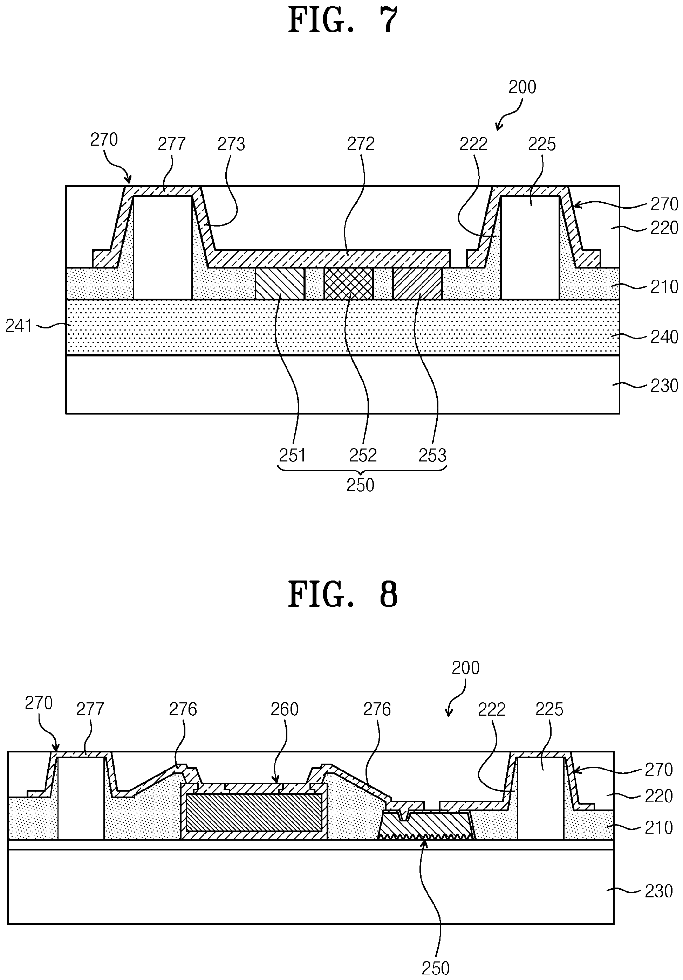

FIG. 7 is a cross-sectional view illustrating a light-emitting element package according to a fourth embodiment of the present disclosure.

Referring to FIG. 7, the light-emitting element package 200 according to the fourth embodiment of the present disclosure has a structure in which the connection electrode 270 has a function of the terminal 280.

In an embodiment, the terminal 280 may be omitted, and a seventh contact and connection portion 277 of the connection electrode 270 may function as the terminal 280.

In one example, the connection electrode 270 may include the seventh contact and connection portion 277 that functions as the terminal, the second contact and connection portion 272 contacting and connected to the light-emitting elements 251, 252, and 253, and the third contact and connection portion 273 connected to and disposed between the seventh contact and connection portion 277 and the second contact and connection portion 272. In this regard, the third contact and connection portion 273 may have an inclination angle corresponding to that of the inclined portion 222.

Compared to the first embodiment shown in FIG. 1, an area of the seventh contact and connection portion 277 may be larger than that of the first contact and connection portion 271 of the first embodiment. As described above, the seventh contact and connection portion 277 having the expanded area may function as the terminal 280 connected to an external electrode pad.

Accordingly, a diameter of the pillar-shaped structure 225 may be expanded. That is, referring to FIG. 7, the pillar-shaped structure 225 may have a wider cross-sectional area so as to function as the terminal. The area of the seventh contact and connection portion 277 positioned on an end of the pillar-shaped structure 225 may also have a large area.

The description of other parts not described herein may be the same as the description as set forth above with respect to the first embodiment. Therefore, a redundant description thereof will be omitted.

FIG. 8 is a cross-sectional view illustrating a light-emitting element package according to a fifth embodiment of the present disclosure.

Referring to FIG. 8, the light-emitting element package 200 according to the fifth embodiment of the present disclosure may include the light-emitting layer 210 (or a first layer) in which the light-emitting unit 250 including the light-emitting elements 251, 252, and 253 is located. In this regard, the driving element 260 may be positioned on one side of the light-emitting unit 250 and in the light-emitting layer 210.

When the driving element 260 as described above is provided, the connection electrode 270 may further include the fourth contact and connection portion 276 connected to the driving element 260. One side of the fourth contact and connection portion 276 may be connected to the connection electrode 270, and the other side of the fourth contact and connection portion 276 may be connected to the light-emitting unit 250.

In one example, the connection electrode 270 may include the seventh contact and connection portion 277 that functions as a terminal, the second contact and connection portion 272 contacting and connected to the light-emitting elements 251, 252, and 253, and the third contact and connection portion 273 connected to and disposed between the seventh contact and connection portion 277 and the second contact and connection portion 272. In this regard, the third contact and connection portion 273 may have an inclination angle corresponding to that of the inclined portion 222.

The seventh contact and connection portion 277 may have an area larger than that of the first contact and connection portion 271 of the first embodiment. As described above, the seventh contact and connection portion 277 having the expanded area may function as the terminal 280 connected to the external electrode pad.

The description of other parts not described herein may be the same as the descriptions of the first embodiment and the fourth embodiment. Therefore, a redundant description thereof will be omitted.

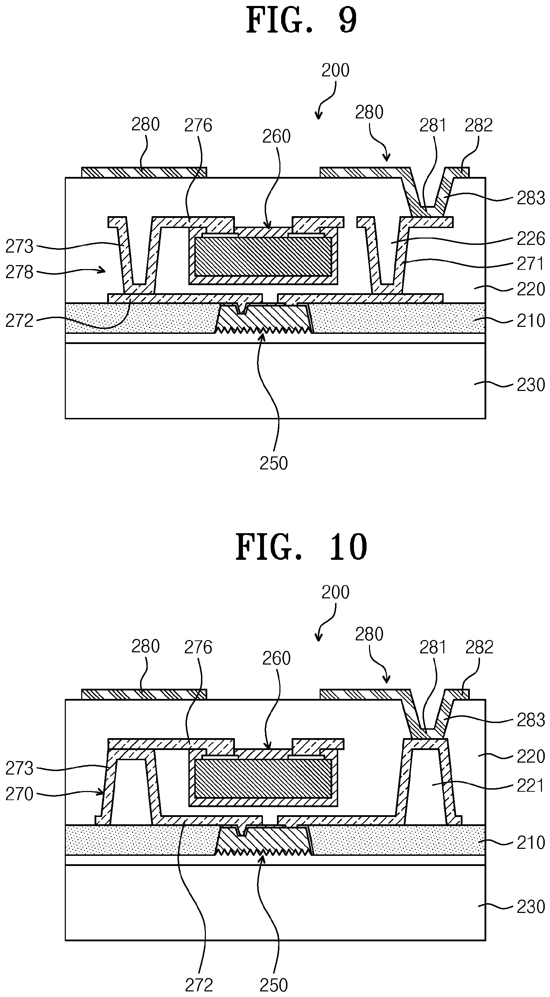

FIGS. 9 to 11 are cross-sectional views illustrating a light-emitting element package according to a sixth embodiment of the present disclosure and a modified example thereof.

Referring to FIGS. 9 to 11, the light-emitting element package 200 according to the sixth embodiment of the present disclosure may include the light-emitting layer 210 (or a first layer) in which the light-emitting unit 250 including light-emitting elements 251, 252, and 253 is located.

The connection layer 220 (or a second layer) including the terminal 280 and the plurality of connection electrodes 278 connected to and disposed between the terminal 280 and the light-emitting elements 251, 252, and 253 may be positioned on the light-emitting layer 210 in which the light-emitting unit 250 is located.

The support layer 230 (or a third layer) through which light emitted from the light-emitting unit 250 passes may be positioned on the lower surface of the light-emitting layer 210. That is, light generated from the light-emitting unit 250 may be emitted through the support layer 230. As described above, the light-emitting element package shown in FIG. 5 may be a bottom emission type light-emitting element package in which light is emitted downwardly of the structure shown in FIG. 5.

The driving element 260 may be positioned in the connection layer 220. In this regard, the driving element 260 is positioned on the light-emitting unit 250, such that the driving element 260 and the light-emitting unit 250 may at least partially overlap each other in the vertical direction.

In one example, the driving element 260 and the light-emitting unit 250 may be arranged in a line in the stacking direction of the light-emitting layer 210, the connection layer 220, and the support layer 230.

Referring to FIG. 9, each of the connection electrode 270 and the inclined portion 226 may have a shape inverted from that in the first embodiment. In one example, in the case of the first embodiment, the connection electrode 270 may have a shape convex upwards, while referring to FIG. 9, the connection electrode 278 may have a shape convex downwards.

In one example, the inclined portion 226 may have a shape in which the cross-sectional area thereof is decreased as the inclined portion extends downwards, and accordingly, the connection electrode 278 may include the first contact and connection portion 271 contacting and connected to the terminal 280, the second contact and connection portion 272 contacting and connected to the light-emitting elements 251, 252, and 253, and the third contact and connection portion 273 connected to the second contact and connection portion 272. In this regard, each of the first contact and connection portion 271 and the third contact and connection portion 273 may have an inclination angle corresponding to that of the inclined portion 226. In addition, the second contact and connection portion 272 may be connected to an end of each of the first contact and connection portion 271 and the third contact and connection portion 273.

When the driving element 260 as described above is provided, the connection electrode 270 may further include the fourth contact and connection portion 276 connected to the driving element 260.

Referring to FIG. 9, the terminal 280 at one side may have a flat plate shape, and the terminal 280 at the other side may have a pillar structure corresponding to the connection electrode 270. In one example, the terminal 280 may include the fifth contact and connection portion 281 connected to the first contact and connection portion 271 of the connection electrode 270, the terminal layer 282 serving as a terminal connected to the external electrode pad, and the sixth contact and connection portion 283 connecting the fifth contact and connection portion 281 and the terminal layer 282 to each other.

Referring to FIG. 10, unlike the case of FIG. 9, the connection electrode 270 may have the same shape as that of the first embodiment.

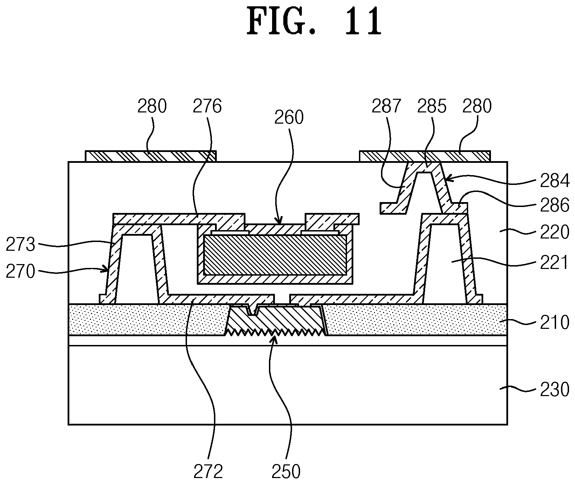

Referring to FIG. 11, each of the both opposing terminals 280 may have a flat plate shape. A separate connection portion 284 may be provided between the terminal 280 and the connection electrode 270.

The connection portion 284 may have a shape similar to that of the connection electrode 270. That is, the connection portion 284 connecting the terminal 280 and the connection electrode 270 to each other may include an eighth contact and connection portion 285 connected to the terminal 280, a ninth contact and connection portion 286 connected to the connection electrode 270, and a tenth contact and connection portion 287 connecting the eighth contact and connection portion 285 and the ninth contact and connection portion 286 to each other. In this regard, the tenth contact and connection portion 287 may have an inclination angle rather than a right angle with respect to the terminal 280.

In the structure in which the driving element 260 and the light-emitting unit 250 are stacked so as to overlap each other as described above, due to the thickness of the driving element 260, an opening of a considerable depth may be required for electrical connection thereof with the underlying light-emitting unit 250. A thick wiring connection may usually be selected through plating for the stable electrical connection.

In this regard, when the connection electrode 270 and/or the terminal 280 having the side surface of the smaller inclination is formed using the proposed up-heel structure, the driving element 260 may be electrically connected to the light-emitting unit 250 while the driving element 260 has a height similar to that of the terminal 280, and thus, stable connection therebetween may be made using a thin film wiring.

In addition, when the up-hill structure is formed in a double manner using the connection electrode 270 and/or the terminal 280, the area of the terminal 280 may be improved, and at the same time, the thickness of the light-emitting element package 200 may be manufactured to be greater.

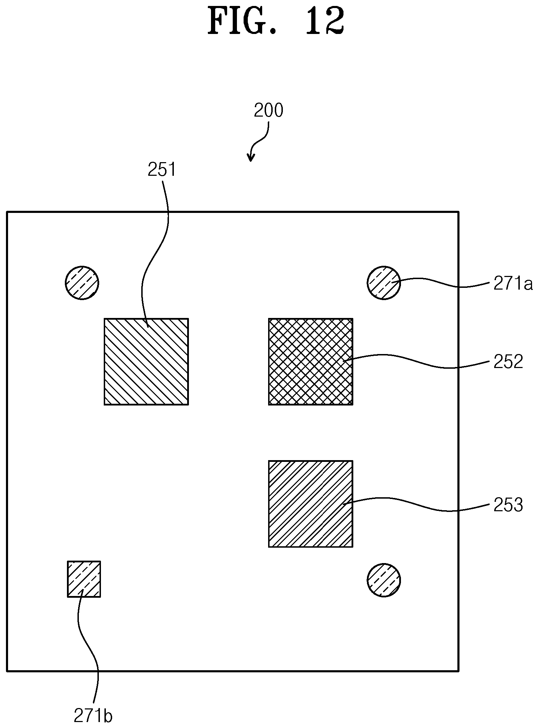

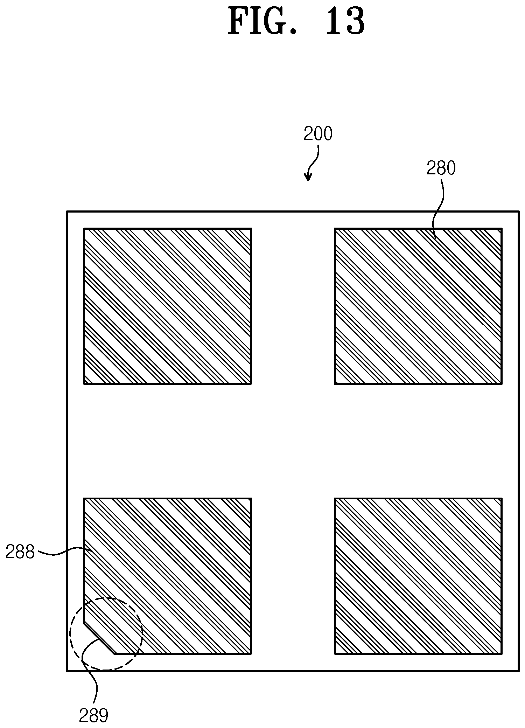

FIG. 12 is a schematic diagram illustrating an example in which a connection electrode is used as an alignment key according to embodiments of the present disclosure, and FIG. 13 is a schematic diagram illustrating an example in which a terminal is used as an alignment key according to embodiments of the present disclosure.

Referring to FIG. 12, an example in which a portion of the connection electrode 270 as described above is used as an alignment key is illustrated.

In one example, shapes of the first contact and connection portions 271a and 271b of the connection electrode 270 may be different from each other such that the first contact and connection portions 271a and 271b of the connection electrode 270 may be used as the alignment key. In one example, one first contact and connection portion 271b of the connection electrode 270 used as the common electrode may be formed in a different shape from that of another first contact and connection portion 271b of the connection electrode 270 such that one first contact and connection portion 271b and another first contact and connection portion 271b are distinguished from each other.

As described above, when a state in which each of the connection electrodes 270 is connected to and disposed between the light-emitting unit 250 and the driving element 260 can be intuitively identified from the outside, it may be easy to match the terminal of the wiring substrate with the connection electrode in the mounting process of the light-emitting element package 200.

Referring to FIG. 13, a terminal 288 connected to the common electrode may be formed in a different shape from that of each of the remaining terminals 280.

In one example, the terminal 288 connected to the common electrode may be partially cut off in an oblique line 289 so as to be distinguished from each of the other terminals 280.

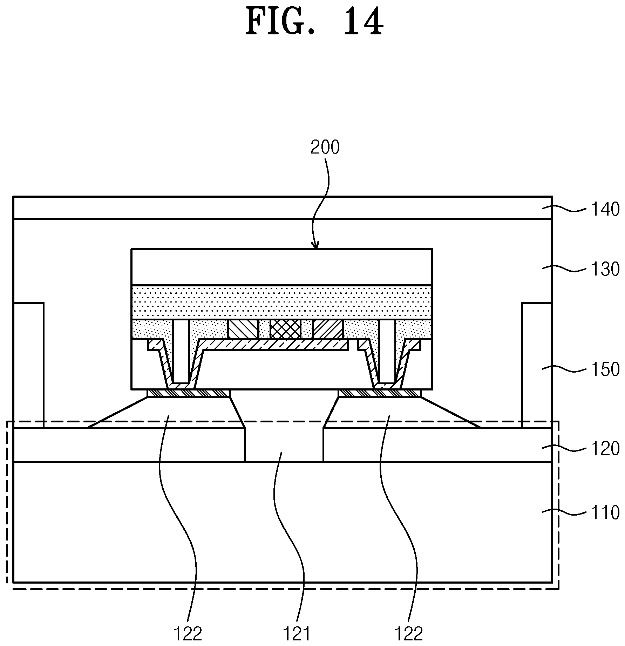

FIG. 14 is a cross-sectional schematic diagram illustrating a display device using the light-emitting element package according to the first embodiment of the present disclosure.

FIG. 14 illustrates an example of a display device in which the light-emitting element package 200 according to the first embodiment as described above with reference to FIGS. 1 and 2 is used as a unit pixel.

Referring to FIG. 14, the light-emitting element package 200 may be oriented in a state inverted relative to that in FIG. 1 and may be disposed on a wiring substrate 100 including a substrate 110 and a wiring electrode 120 formed on the substrate 110. The light-emitting element package 200 and the wiring substrate 100 may constitute a display device 10. In this regard, the wiring electrodes 120 may be spaced from each other with a spacing 121 being defined therebetween.

The light-emitting element package 200 may be connected to the wiring electrode 120 via an electrical contact and connection portion 122 such as a solder 122.

A molding layer 130 filling a space around the light-emitting element package 200 may be disposed on the substrate 110. An optical layer 140 may be disposed on the molding layer 130.

In some cases, a black matrix 150 may be disposed on a side surface of each light-emitting element package 200.

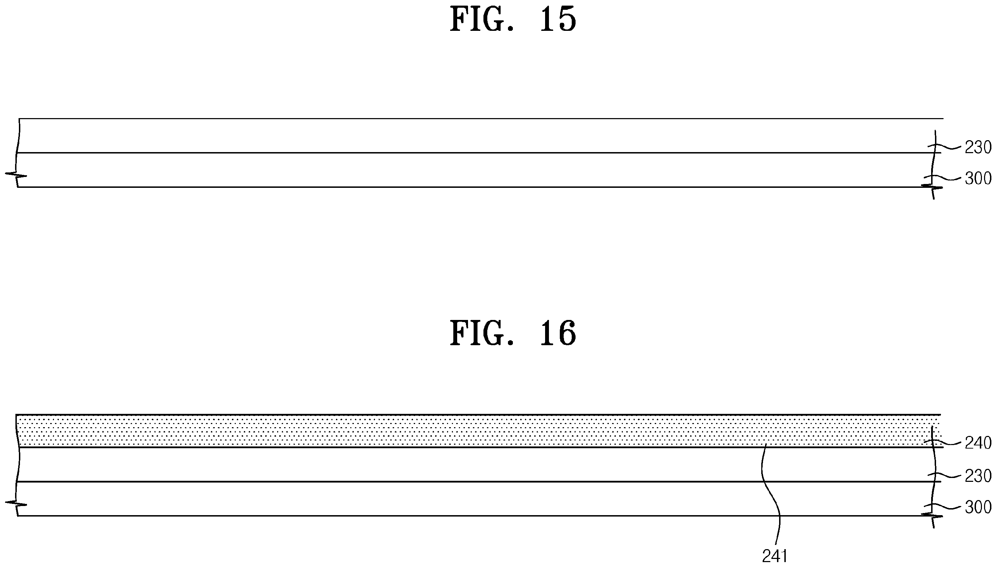

FIGS. 15 to 24 are cross-sectional views illustrating a process of manufacturing the light-emitting element package according to the first embodiment.

Hereinafter, the process of manufacturing the light-emitting element package 200 according to the first embodiment will be described with reference to FIGS. 15 to 24.

Referring to FIG. 15, first, the support layer 230 may be formed on a process substrate 300. In one example, the support layer 230 may be coated on the process substrate 300.

Referring to FIG. 16, the scattering layer 240 may be formed on the support layer 230. In one example, the scattering layer 240 may also be coated on the support layer 230. As described above, the scattering layer 240 may contain therein the fine particles 241.

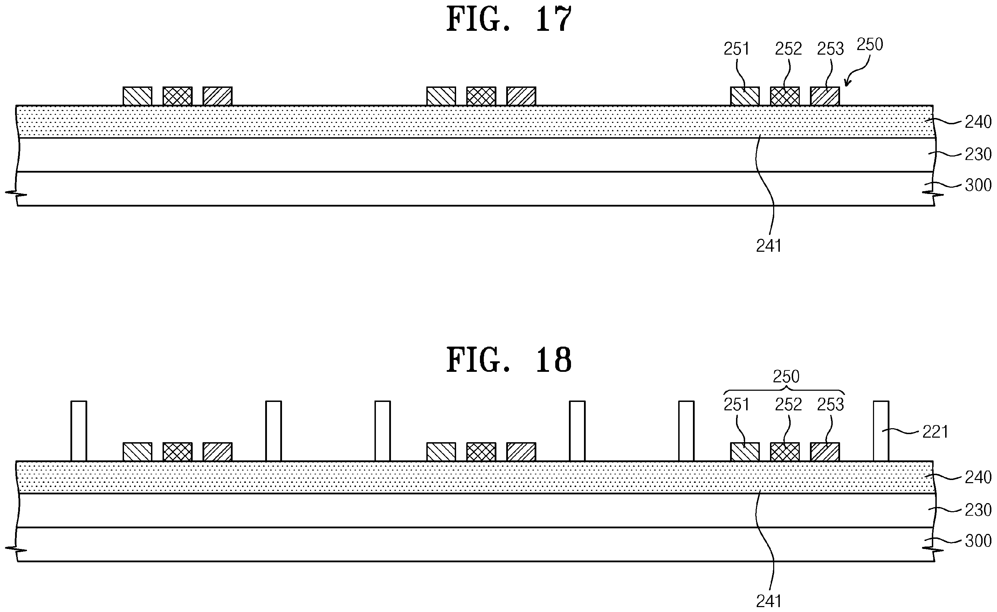

Referring to FIG. 17, the light-emitting elements 251, 252, and 253 constituting the light-emitting unit 250 may be transferred onto the scattering layer 240.

Thereafter, referring to FIG. 18, the pillar-shape 221 may be formed between adjacent ones of the light-emitting units 250. In one example, the pillar-shape 221 may be respectively formed in four places around each light-emitting unit 250. The position in the plan view of the pillar-shape 221 may correspond to the position in the plan view of the first contact and connection portion 271 shown in FIG. 2.

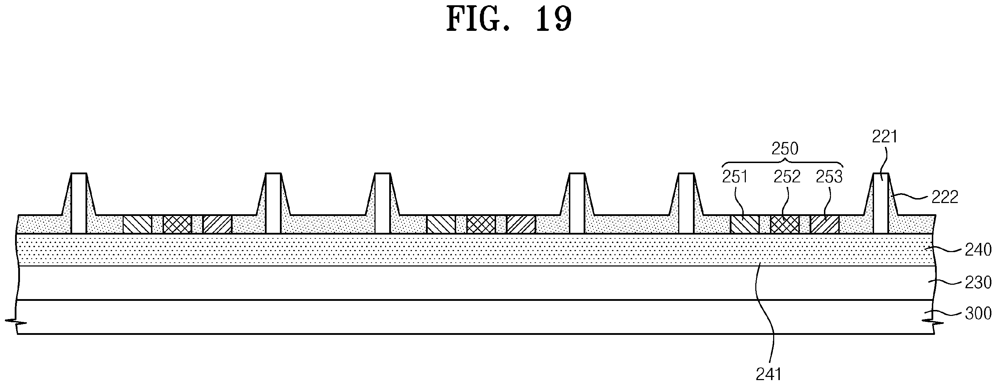

Referring to FIG. 19, the inclined portion 222 may be formed on the outer surface of the pillar-shape 221. In one example, the inclined portion 222 may be formed so as to be continuously with a portion molding the light-emitting unit 250. In one example, the inclined portion 222 may be connected to a side surface of the light-emitting unit 250.

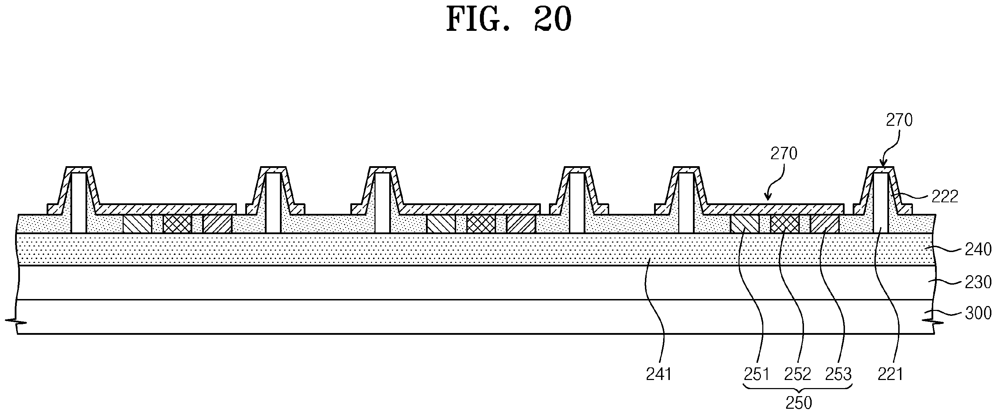

Referring to FIG. 20, the connection electrode 270 may be formed in a patterned manner along the outer surface of the pillar-shape 221 and the inclined portion 222. The connection electrode 270 may be electrically connected to the light-emitting unit 250.

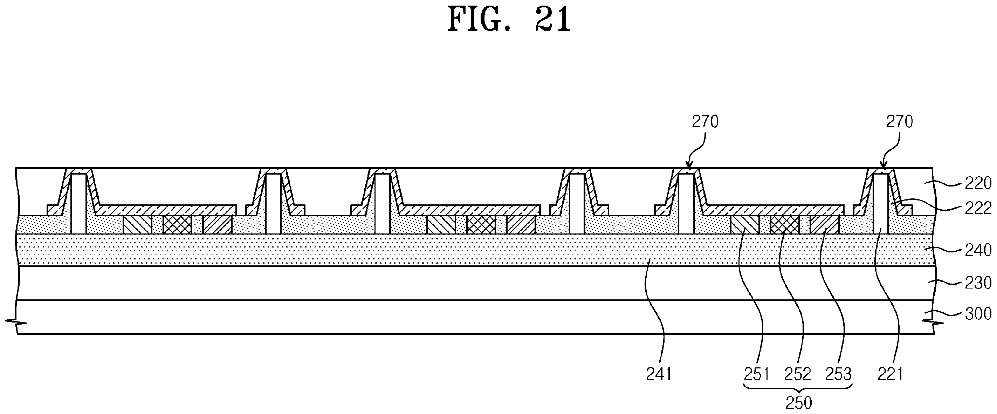

Referring to FIG. 21, the connection layer 220 covering the connection electrode 270 may be formed. In one example, the connection layer 220 may be formed by forming a layer to cover the entirety of the connection electrode 270 and then removing a portion of the covered layer so that the first contact and connection portion 271 of the connection electrode 270 is exposed.

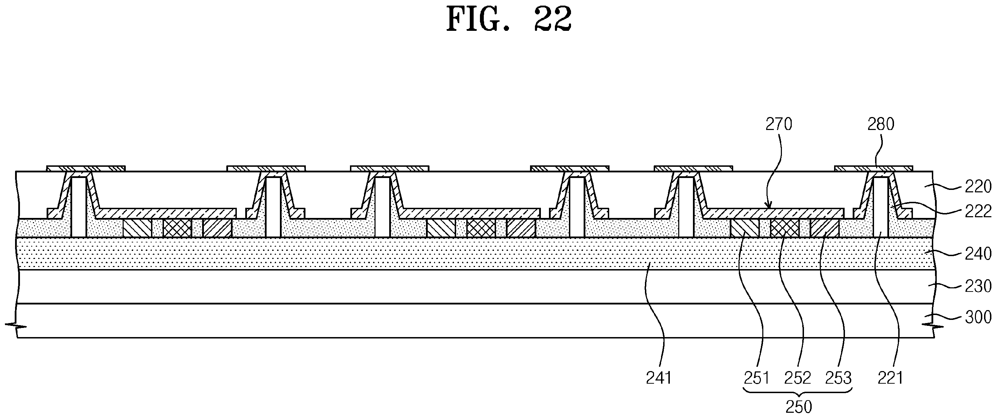

Referring to FIG. 22, the terminal 280 electrically connected to the connection electrode 270 may be formed in a patterned manner.

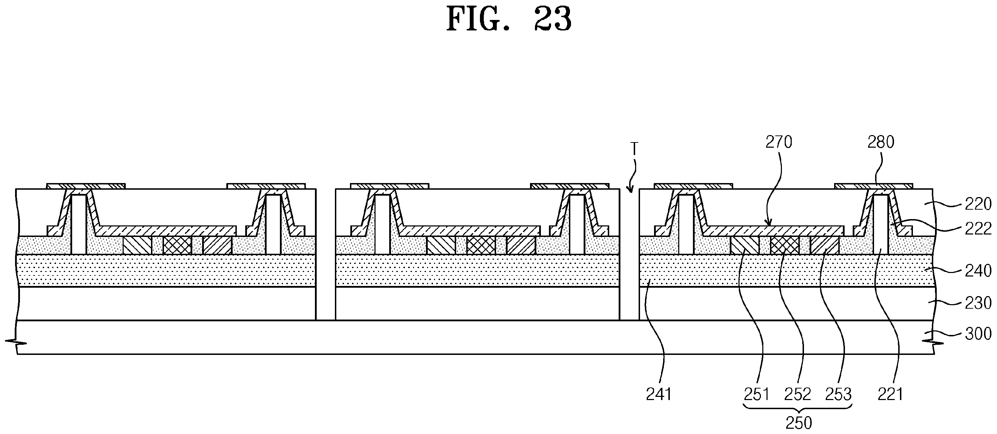

Referring to FIG. 23, a trench T may be formed to define each of individual light-emitting element packages 200. The trench T may be formed by remove a portion between the individual light-emitting element packages 200 so as to isolate the individual light-emitting element packages 200 from each other.

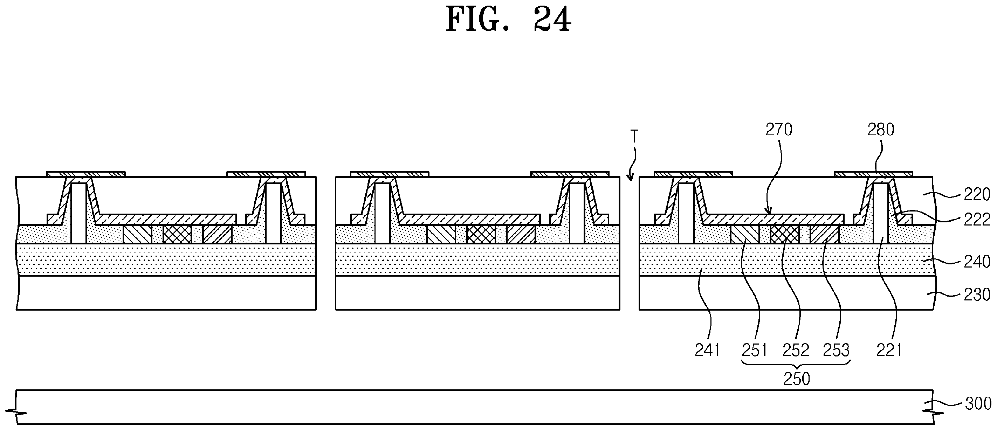

Thereafter, referring to FIG. 24, the process substrate 300 may be removed from the support layer 230. When, as described above, the process substrate 300 has been removed therefrom, the light-emitting element package 200 according to the first embodiment as shown in FIGS. 1 and 2 may be manufactured.

The foregoing description is merely illustrative of the present invention, and various modifications and variations may be made by those skilled in the art to which the present invention pertains without departing from the essential features of the present invention.

Accordingly, the embodiments disclosed herein are intended to illustrate the present invention and not to limit the present invention, and the scope of the present invention is not limited by such embodiments.

The scope of protection of the present invention shall be determined by the appended claims, and all modifications and equivalents falling within the scope of the claims are intended to be included within the scope of the present invention.

### Industrial Applicability

According to the present invention, a semiconductor light-emitting device such as a micro-LED and a display device using the same can be provided.

## Claims

1. A light-emitting element package comprising:
a first layer including a light-emitting unit including light-emitting elements, each light-emitting element constituting a unit sub-pixel;
a second layer disposed on a first surface of the first layer, wherein the second layer includes a terminal and a plurality of connection electrodes connecting the terminal to the light-emitting elements; and
a third layer disposed on a second surface of the first layer, wherein light emitted from the light-emitting unit passes through the third layer,
wherein the connection electrode has a pillar structure having a vertical length corresponding to a vertical spacing between the terminal and the light-emitting elements, wherein the pillar structure has an inclination angle with respect to the first surface.

2. The light-emitting element package of claim 1, wherein the connection electrode is positioned on an outer surface of a pillar-shape provided in the second layer.

3. The light-emitting element package of claim 1, wherein the connection electrode has an inclination angle with respect to the pillar-shape.

4. The light-emitting element package of claim 1, wherein an inclined portion having an inclination angle is positioned on an outer surface of the pillar-shape.

5. The light-emitting element package of claim 1, wherein the connection electrode includes:
a first contact and connection portion contacting and connected to the terminal; and
a second contact and connection portion contacting and connected to the light-emitting element.

6. The light-emitting element package of claim 5, wherein the connection electrode further includes a third contact and connection portion connected to and disposed between the first contact and connection portion and the second contact and connection portion.

7. The light-emitting element package of claim 6, wherein the third contact and connection portion has the inclination angle.

8. The light-emitting element package of claim 1, wherein the terminal has a pillar structure corresponding to the connection electrode.

9. The light-emitting element package of claim 1, further comprising a driving element disposed on one side of the light-emitting element.

10. The light-emitting element package of claim 1, further comprising a fourth layer disposed between the third layer and the first layer and containing scattering particles therein.

11. The light-emitting element package of claim 1, wherein the second layer functions as a reflective layer.

12. A light-emitting element package comprising:
a light-emitting layer including a light-emitting unit including light-emitting elements, each light-emitting element constituting a unit sub-pixel;
a connection layer disposed on a first surface of the light-emitting layer, wherein the connection layer includes a terminal and a plurality of connection electrodes connected to and disposed between the terminal and the light-emitting elements; and
a support layer disposed on a second surface of the light-emitting layer, wherein light emitted from the light-emitting unit passes through the support layer,
wherein the connection electrode has a metal pattern shape positioned on a pillar-shape including an inclined portion provided in the connection layer.

13. The light-emitting element package of claim 12, wherein the metal pattern is positioned on an outer surface of the pillar-shape provided in the connection layer.

14. The light-emitting element package of claim 12, wherein the connection electrode includes:
a first contact and connection portion contacting and connected to the terminal; and
a second contact and connection portion contacting and connected to the light-emitting element.

15. The light-emitting element package of claim 14, further comprising: a third contact and connection portion connected to and disposed between the first contact and connection portion and the second contact and connection portion.

16. The light-emitting element package of claim 15, wherein the third contact and connection portion has an inclination corresponding to an inclination of the inclined portion.

17. The light-emitting element package of claim 12, further comprising a driving element disposed on one side of the light-emitting element.

18. The light-emitting element package of claim 12, further comprising a scattering layer disposed between the light-emitting layer and the support layer and containing scattering particles therein.

19. The light-emitting element package of claim 12, wherein the terminal has a pillar structure corresponding to the connection electrode.

20. A display device including a light-emitting element package defining an individual pixel,
wherein the light-emitting element package comprises:
a light-emitting layer including a light-emitting unit including light-emitting elements, each light-emitting element constituting a unit sub-pixel;
a connection layer disposed on a first surface of the light-emitting layer, wherein the connection layer includes a terminal and a plurality of connection electrodes connected to and disposed between the terminal and the light-emitting elements; and
a support layer disposed on a second surface of the light-emitting layer, wherein light emitted from the light-emitting unit passes through the support layer,
wherein the connection electrode has a metal pattern shape positioned on a pillar-shape including an inclined portion provided in the connection layer.
